# EUROPEAN PATENT APPLICATION

(11) **EP 2 439 766 A1**
(43) Date of publication of application: **11.04.2012**
(21) Application number: 11182868.7
(22) Date of filing: 27.09.2011
(51) Int. Cl.: H01L 21/02, H01L 21/306, H01L 31/0236

(54) **Method of forming micro-pore structures or trench structures on surface of silicon wafer substrate**

(30) Priority: 08.10.2010 TW 99134358
(71) Applicant: Wakom Semiconductor Corporation, Hsinchu County 30352 (TW)
(72) Inventor: Chien, Ray, 30352 Hsinchu County (TW); Lion, Yu-Mei, 30352 Hsinchu County (TW); Kao, Wei-Che, 30352 Hsinchu County (TW); Cchiang, Yi-Ling, 30352 Hsinchu County (TW)
(74) Representative: Bonvicini, Davide

(57) **Abstract**

A method of forming micro-pore structures or trench structures on a surface of a silicon wafer substrate comprises (A) forming at least a noble-metal alloy particle on the surface of the silicon wafer substrate; and (B) then followed by employing a chemical wet etching on the surface of the silicon wafer substrate. During the processes, noble-metal alloy particle is used to catalyze the oxidation of the silicon wafer substrate surface in contact therewith, and an etchant is used to simultaneous etch the silicon dioxide to result in local micro-etching at the surface of the silicon wafer substrate, thereby forming micro-pore structures or trench structures on the surface of the silicon wafer substrate. The method increases the power conversion efficiency of the solar cells and reduces the manufacturing costs so as to increase the production benefits of the solar cells.

## Description

### FIELD OF THE INVENTION

This invention relates to a method of forming micro-pore structures or trench structures on a surface of a silicon wafer substrate, and more particularly to a chemical wet etching method using noble-metal alloy particles as a silicon etching catalyst to formmicro-pore structures or trench structures on a surface of a silicon wafer substrate.

### BACKGROUND OF THE INVENTION

Global energy (particularly petroleum) price has been rising recently with an ever-increasing energy demand. Renewable energy is a type of eco-friendly green energy, among which solar cells are very promising sources of clean energy used to generate electric power directly from sunlight. As an energy conversion photovoltaic component, solar cells can convert the energy of sunlight into electric power. However, before they are widely accepted as a primary electric power source, costs of solar cells must be reduced significantly first. Some researches indicate that the costs of silicon wafer account for one-third of the overall costs of crystalline silicon solar cell modules. Accordingly, to reduce the costs, using crystalline silicon wafer substrates to fabricate solar cells and increasing the power generation efficiency of solar cells have become important directions of development.

Conventional crystalline silicon solar cells has a layered stack structure mainly comprising a silicon wafer substrate, a surface passivation/anti-reflection layer and a pair of electrodes, and the silicon wafer substrate comprises a shallow P-N junction. One of the functions of the surface passivation/anti-reflection layer is to reduce incident light reflection and, in other words, to promote light absorption of the silicon wafer substrate to increase incident photon-to-current conversion efficiency.

Generally, in addition to the surface passivation/anti-reflection layer, the light-catching surface, i.e. the upper surface of a silicon wafer substrate will be processed in advance by a surface texturing method to further reduce incident light reflection so as to lower reflection loss and improve light-trapping characteristics.

Recently all high performance crystalline silicon solar cells have their surface processed by surface texturing method to form micro-pore structures or uneven structures on the surfaces of silicon wafer substrates by wet etching, and surfactant can be optionally added during the wet process to optimize the wet texturing process.

References 1 to 4, which are patent documents, all disclose a method of making a porous silicon wafer substrate, in which a silicon wafer substrate with its surface coated by noble-metal element (such as platinum, silver, gold or palladium) particle is soaked in the solution of hydrogen fluoride and hydrogen peroxide to form a nanometer scale micro-porous layer on the surface of the silicon wafer substrate by chemical etching of silicon. However, the aforementioned method requires deposition of expensive noble-metal element (such as silver element) prior to chemical etching, thereby resulting in rather high production costs.

In addition, the formation of textured micro-pore structures on the surface of a silicon wafer substrate is critical to the fabrication of various elements, such as trench capacitors for semiconductor memories (Reference 5), through-wafer-via electrodes for semiconductor wafer level packaging (Reference 6) and nozzle plates of an ink-jet printer (Reference 7). Therefore, it is highly desirable to semiconductor engineers to form a silicon wafer substrate with a surface having uneven structures or porous structures to increase the surface area thereof.

Accordingly, this invention is intended to provide a method of forming micro-pore structures or trench structures on a surface of a silicon wafer substrate, which can obviate some drawbacks of prior arts, reduce the fabrication costs and reduce the production costs of solar cells.

Reference 1: U.S. Patent No. 6790785 B1.

Reference 2: U.S. Patent No. 7135414 B2 .

Reference 3: Japanese Patent Publication No. 2007-194485.

Reference 4: U.S. Patent No. 7718254 B2 .

Reference 5: Japanese Patent Publication No. 2004-514276.

Reference 6: Japanese Patent Publication No. 2004-95849.

Reference 7: Japanese Patent Publication No. 11-268281.

### SUMMARY OF THE INVENTION

In view of the aforementioned drawbacks in prior arts, inventors of this application, with their experiences in the industry, devoted themselves to the study of a novel method of forming micro-pore structures or trench structures on a surface of a silicon wafer substrate, in hopes of lowering the manufacturing costs and reducing the production costs of solar cells.

It is a main objective of this invention to provide a method of forming micro-pore structures or trench structures on a surface of a silicon wafer substrate. During the wet process in a solution, noble-metal alloy particles catalyze the oxidation of the silicon layer in contact therewith on the silicon wafer substrate surface to form silicon dioxide, which is simultaneoutly etched away by fluoride ion in the solution. The continuous reaction of silicon oxidation and silicon dioxide etching results in local micro-etching at the surface of the silicon wafer substrate in contact with the noble-metal alloy particles, thereby gradually forming micro-pore structures or trench structures on the surface of the silicon wafer substrate. These micro-pore structures or trench structures decrease the surface reflectivity of the wafer, increase power conversion efficiency of solar cells, and reduce the manufacturing costs by reducing the amount of noble-metal used during the process, so as to increase the production benefits of solar cells.

To achieve the aforementioned objective, this invention provides a method of forming micro-pore structures or trench structures on a surface of a silicon wafer substrate, the method comprising:

(A) forming at least a noble-metal alloy particle on the surface of the silicon wafer substrate, the noble-metal alloy particle comprising at least one of the following noble-metal elements: silver (Ag), gold (Au), platinum (Pt) or palladium (Pd); in a preferred embodiment, binary alloy particle of noble-metal is formed in step (A), such as the binary alloy particle formed by silver and a non-noble-metal element which is usually a metallic element; and

(B) followed by employing an aqueous etchant solution to perform a chemical wet etching process on the surface of the silicon wafer substrate, the aqueous etchant solution comprising at least one acidic compound capable of releasing fluoride ion in the aqueous etchant solution and at least one oxygen-containing oxidizer.

In this invention, noble-metal alloy particles formed on the surface of the silicon wafer substrate surface catalyze the oxidation of silicon in contact therewith, and fluoride ion in the aqueous solution etches the silicon dioxide formed thereby. The simultaneous and continuous reactions of oxidation and etch result in local micro-etching effect and and gradually form micro-pore structures or trench structures on the surface of the silicon wafer substrate.

In step (A) of the aforementioned method, if the alloy is a binary alloy formed by a noble-metal element and a non-noble-metal metallic element, not all composition ratio of the two elements can form a single-phase binary alloy at room temperatures and under normal pressure. In the example of Ag₁₋ₓZnₓ binary alloy (x represents atomic percentage), when x<~0.3 (i.e. 30%) at room temperatures, a stable face-centered cubic phase (FCC phase) Ag₁₋ₓZnₓ binary alloy can be formed; when x is in the range of 0.35> x >~0.3, a biphasic, mixed-phase binary alloy can be formed. In addition, in the example of Ag₁₋ₓNiₓ (x represents atomic percentage), when x >~0.001 (i.e. 0.1%) at room temperatures and under normal pressure, no eutectic alloy phase can be formed, but only a bi-metallic mixture of Ag and Ni is formed. Therefore, in general not all non-noble-metal elements are capable of forming an eutectic alloy phase with a noble-metal element, at room temperatures (or slightly levitated temperatures) under normal pressure.

In step (A) of the aforementioned method, non-noble-metal elements that can form an eutectic alloy phase with noble-metal elements such as silver, gold, platinum, and palladium generally comprise aluminum (Al), gallium (Ga), indium (In), magnesium (Mg), tin (Sn), zinc (Zn), chromium (Cr), copper (Cu), manganese (Mn), nickel (Ni), cobalt (Co) or antimony (Sb) or others ,and preferably comprise zinc, tin or indium.

In step (A) of the aforementioned method, the noble-metal alloy is a binary alloy of silver, such as silver-aluminum (Ag-Al) alloy, silver-gallium (Ag-Ga) alloy, silver-indium (Ag-In) alloy, silver- magnesium (Ag-Mg) alloy, silver-tin (Ag-Sn) alloy, silver-zinc (Ag-Zn) alloy or silver-manganese (Ag-Mn) alloy. Each of the non-noble-metal elements mentioned above can form a (single-phase) binary alloy with silver at room temperatures under normal pressure when their composition ratio is low, examples are Ag₁₋ₓSnₓ(x<0.08), Ag₁₋ₓInₓ(x<0.20), Ag₁₋ₓAlₓ(x<0.06), Ag₁₋ₓMgₓ(x<0.18) or Ag₁₋ₓZnₓ(x<0.30) and others, wherein x represents atomic percentage.

The noble-metal alloy is a binary alloy of gold, such as gold-aluminum (Au-Al) alloy, gold-chromium (Au-Cr) alloy, gold-gallium (Au-Ga) alloy, gold-copper (Au-Cu) alloy, gold-indium (Au-In) alloy, gold-manganese (Au-Mn) alloy, gold-tin (Au-Sn) alloy or gold-zinc (Au-Zn) alloy. Each of the non-noble-metal elements mentioned above can form a (single-phase) binary alloy with gold at room temperatures under normal pressure when their composition ratio is low, examples are Au₁₋ₓAlₓ(x<0.08), Au₁₋ₓInₓ(x<0.08), Au₁₋ₓGaₓ(x<0.02), Au₁₋ₓSnₓ(x<0.04) or Au₁₋ₓZnₓ(x<0.12) and others, wherein x represents atomic percentage.

The noble-metal alloy is a binary alloy of platinum, such as platinum-aluminum (Pt-Al) alloy, platinum-copper (Pt-Cu) alloy, platinum-indium (Pt-In) alloy, platinum-magnesium (Pt-Mg) alloy, platinum-tin (Pt-Sn) alloy, platinum-zinc (Pt-Zn) alloy, platinum-manganese (Pt-Mn) alloy, platinum-nickel (Pt-Ni) alloy or platinum-cobalt (Pt-Co) alloy. Each of the non-noble-metal elements mentioned above can form a (single-phase) binary alloy with platinum at room temperatures under normal pressure when their composition ratio is low.

Alternatively, the noble-metal alloy is a binary alloy of palladium, such as palladium-aluminum (Pd-Al) alloy, palladium-copper (Pd-Cu) alloy, palladium-indium (Pd-In) alloy, palladium-magnesium (Pd-Mg) alloy, palladium-tin (Pd-Sn) alloy, palladium-zinc (Pd-Zn) alloy, palladium-manganese (Pd-Mn) alloy, palladium-nickel (Pd-Ni) alloy or palladium-cobalt (Pd-Co) alloy. Each of the non-noble-metal elements mentioned above can form a (single-phase) binary alloy with palladium at room temperatures under normal pressure when their composition ratio is low.

In step (A) of the aforementioned method, since noble-metal elements like silver, gold, platinum or palladium can form an eutectic binary alloy phase with each other (e.g. Ag₁₋ₓPdₓ, Ag₁₋ₓAuₓ, Au₁₋ₓPdₓ and Pt₁₋ₓPdₓ, wherein 0.01<x<0.95, and x represents atomic percentage) at a wide range of composition ratio, if the binary alloy is constituted of two noble-metal elements, the binary alloy comprises: silver-gold (Ag-Au) alloy, silver-platinum (Ag-Pt) alloy, silver-palladium (Ag-Pd) alloy, gold-platinum (Au-Pt) alloy, gold-palladium (Au-Pd) alloy or platinum-palladium (Pt-Pd) alloy.

In step (A) of the aforementioned method, the noble-metal alloy may also be a ternary alloy or a quaternary alloy.

In step (A) of the aforementioned method, the particle feature scale of the noble-metal alloy particle may range from 1 nanometer to 5000 nanometers and preferably from 30 nanometers to 3000 nanometers.

In step (A) of the aforementioned method, the alloy particles may be formed by using an alloy electroless co-plating technique to deposit granular or islet-like noble-metal alloy particle on the surface of the silicon wafer substrate. For example, because silicon has a lower chemical activity, the electroless plating of silver ion on the surface of the silicon wafer substrate is a kind of autocatalytic reduction reaction, by which the silver ion is reduced to silver atom and is gradually deposited to form silver particles.

Chemical(s) of the electroless co-plating technique can generally adopt different metal salts with the same chemical group as the sources of different metal ions, yet metal salts with the different chemical groups may also be used as the sources of different metal ions. For example, in the electroless co-plating deposition of Ag₁₋ₓZnₓ (x represents atomic percentage), aqueous solution containing silver nitrate (AgNO₃) and zinc nitrate (Zn(NO₃)₂) may be used. With proper adjustment of pH value, ionic concentration and temperature of the aqueous solution, silver ion and zinc ion in the aqueous solution can be reduced simultaneously on the silicon wafer substrate to form co-deposition. During the electroless co-plating deposition of Ag₁₋ₓZnₓ on the silicon wafer substrate in the aqueous solution, because silver has a standard reduction potential (E⁰) about +0.8V, which is far greater than that of zinc (with a negative E⁰), the reduction rate of silver ion on the silicon wafer substrate in the aqueous solution is (much) faster than that of the zinc ion; therefore, a (much) higher molar concentration ratio of zinc ion in the aqueous solution (compared to silver ion concentration) is needed in order to form a desired x ratio in the Ag₁₋ₓZnₓ alloy (x represents atomic percentage) after co-deposition. Empirically, the molar concentration ratio of zinc ion to silver ion in the aqueous solution needs to be several times higher than x/(1-x), in order to facilitate the continuous reaction of electroless co-plating by the two ions (zinc ion and silver ion in this example) to gradually form the desired silver zinc alloy Ag₁₋ₓZnₓ particle.

The electroless co-plating technique suitable for the deposition of noble-metal alloy particles other than silver alloy is similar to that of the silver alloy, and can be implemented by a chemical process under similar principles. For example, Pd₁₋ₓZnₓ binary alloy can be formed by having palladium dichloride (PdCl₂) pre-dissolved in HCL solution and then mixed with chemical solution containing zinc sulfate to facilitate the co-plating deposition of Pd₁₋ₓZnₓ binary alloy particles. In addition, if sodium hypophosphite (as a reducing agent) is added to the electroless co-plating chemical solution, the reaction rate of reduction can be increased, and phosphor can be partially deposited on the surface of the particle, thereby allowing the formation of Pd_{1-x-y}ZnₓP_{y} ternary alloy particle by electroless co-deposition, wherein y is slightly less than 0.01 to 0.02 (i.e. less than 1% to 2%) .

Generally, the temperature, ionic molar concentration and pH value of the chemical solutions used in the electroless co-plating technique will greatly affect the reduction of ions (i.e. atomic deposition rate) and the stability of the chemical solutions. Moreover, a reducing agent can be added in solution to increase the ion reduction rate, so as to increase the deposition rate of metal (atoms). Common reducing agents include, for examples, sodium hypophosphite monohydrate (NaH₂PO₂·H₂O), formaldehyde (CH2O), hydrazine sulfate (N₂H₄·H₂SO₄), Rochelle salt or potassium sodium tartrate (KNaC₄H₄O₆ · 4H₂O).

In addition, owing to the contribution of surface free energy at the surface of noble-metal alloy particle, an alloy phase with a short-range order can be generated more easily at the surface (binary) atoms. The formation of short-range order alloy phase at the surface (of the alloy particle) can be observed by low energy electron diffraction (LEED) and X-ray diffraction (XRD) methods, i.e., the two methods can confirm that short-range order exists in the surface alloy phase of certain noble-metal alloy particles. Furthermore, when the particle feature size is slightly less than 10 nanometers, i.e. when the system is a mesoscopic system, surface free energy provides substantial contribution to the system, such that the system can possibly form a novel (mesoscopic) alloy phase. For example, in a macroscopic system Ag₁₋ₓNiₓ (x represents atomic percentage)cannot form an eutectic ally phase at room temperatures under normal pressure, but when the particle feature size is slightly less than 10 nanometers, a novel nanoparticle alloyphase is formed, which can be confirmed by low energy electron diffraction and X-ray diffraction. Other nanoparticle binary alloy comprises, for example, silver-cobalt (Ag-Co) nanoparticle alloy, gold-cobalt (Au-Co) nanoparticle alloy or gold-nickel (Au-Ni) nanoparticle alloy.

In step (A) of the aforementioned method, other alloy particle formation methods can also be used, such as any one of an alloy electro co-plating technique, an alloy electro-phoresis technique, a stencil printing technique, an ink-jet printing technique, a spraying technique, a sputtering technique and a co-evaporating technique.

The alloy electro co-plating technique and the alloy electro-phoresis technique are somewhat similar to the alloy electroless co-plating technique, except that the former two techniques use external electrodes and external electric currents and use different chemical solutions. If a lower electric current is used within a shorter period of time, a granular or islet-like alloy layer can be deposited on the surface of the silicon wafer substrate.

The stencil printing technique and the ink-jet printing technique use paste or ink containing noble-metal alloy particles, and perform partial coating on the surface of the silicon wafer substrate according to a predefined pattern, and then carry out an extra drying process. In contrast, the spraying technique uses organic solvent containing noble-metal alloy particles, randomly sprays the solvent and the noble-metal alloy particles onto the surface of the silicon wafer substrate on a larger area, and then carries out an extra drying process.

The sputtering technique use the sputter target made of noble-metal alloy to partially or completelydepositthenoble-metalalloy (particles) onto the surface of the silicon wafer substrate, optionally followed by an extra patterning process, such as using a lithography technique or a hard mask to define a pattern and using an etchant to remove the exposed noble-metal alloy layer to determine the distribution of the alloy particle or to deposit the alloy particle as a pre-defined pattern on the surface of the silicon wafer substrate, wherein the etchant can be selected from hydrochloric acid (HCl) aqueous solution, sulfuric acid (H₂SO₄) aqueous solution, nitricacid (HNO₃) aqueous solution and the combination of any two or three.

The co-evaporating technique co-evaporates two or more metal elements onto the surface of the silicon wafer substrate to form a noble-metal alloy layer, optionally followed by an extra patterning process similar to those used in the sputtering technique.

In the aforementioned method, step (B) performs chemical wet etching in an aqueous etchant solution comprising at least one acidic compound capable of releasing fluoride ion therein and at least one oxygen-containing oxidizer.

During the process, noble-metal alloy particle catalyzes the oxidation of the silicon wafer substrate surface in contact therewith to form silicon dioxide, which is simultaneously etched by fluoride ion in the aqueous etchant solution immediately after oxide formation. The continuous silicon oxidation and silicon dioxide etching results in local micro-etching at the surface of the silicon wafer substrate in contact with the noble-metal alloy particle, thereby gradually forms micro-pore structures or trench structures on the surface of the silicon wafer substrate.

In step (B) of the aforementioned method, the acidic compound capable of releasing fluoride ion is ammonium fluoride (NH₄F), ammonium hydrogen fluoride (NH₄HF₂), hydrogen fluoride (HF), metal salt or ammonium salt of hydrogen fluoride, trifluoroacetic acid (CF₃CO₂H), metal salt or ammonium salt of trifluoroacetic acid (CF₃CO₂H), tetrafluoroboric acid (HBF₄), metal salt or ammonium salt of tetrafluoroboric acid, hexafluorosilicic acid ((NH₄)₂(SiF₆)), or metal salt or ammonium salt of hexafluorosilicic acid; preferably, the acidic compound is hydrogen fluoride or ammonium fluoride.

In step (B) of the aforementioned method, the oxidizer is hydrogen peroxide (H₂O₂), ozone (O₃), sodium persulfate (Na₂S₂O₈), potassium permanganate (KMnO₄), nitric acid (HNO₃), ammonium nitrate (NH₄NO₃), sulfuric acid (H₂SO₄), ammonium sulfate (NH₄)₂SO₄), ammonium peroxydisulfate ((NH₄)₂S₂O₈), potassium peroxydisulfate (K₂S₂O₈), perchloric acid (HClO₄), ammonium perchlorate (NH₄ClO₄), sodium perchlorate (NaClO₄), potassium perchlorate (KClO₄), periodic acid (or iodic (VII) acid, HIO₄ 2H₂O), sodiumperiodate (NaIO₄), potassium periodate (KIO₄), methanesulfonic acid (CH₃SO₂OH) or ethylenediamine sulphate (C₂H₁₀N₂SO₄); preferably, the oxidizer is hydrogen peroxide or ozone.

According to the method of this invention, preferably an alloy electroless co-plating technique is used to co-plate and co-deposit two or more (metal) elements onto the surface of the silicon wafer substrate to form noble-metal alloy particles which act as the silicon oxidation catalyst together with the chemical wet etching of oxides . During the wet etching, the catalyst (particle) facilitates the oxidizer in the etchant to oxidize silicon crystal (which is in contact with the outer surface of noble-metal alloy particle) into silicon dioxide; meanwhile, fluoride ion in the wet etchant dissolves the silicon dioxide into the etchant solution. With the simultaneous and continuous reaction, micro-pores or trenches, with a lateral size similar to the particle size of the noble-metal alloy particle, can be formed and developed toward the interior of the silicon wafer substrate, forming micro-pore structures or trench structures on the surface of the silicon wafer substrate and leaving the noble-metal alloy particle at the bottom (deep most part) of the micro-pores or trenches. Preferably, the etchant solution contains a mixture of an oxidizer, such as hydrogen peroxide or ozone, and hydrogen fluoride.

Accordingly, instead of using noble-metal element solely as in the prior arts, this invention allows the use of noble-metal alloy particle(s)formed by non-noble-metal element(s) and noble-metal element(s) (in the example of binary silver alloy, with less than about 30% atomic ratio of zinc, or less than about 8% atomic ratio of tin or less than about 20% atomic ratio of indium, all can form an eutectic binary alloy phase with silver at room temperatures under normal pressure); therefore, compared to a pure noble-metal element catalyst, the amount of noble-metal element in the alloy is lesser by certain amount, and the noble-metal material costs can be reduced, while achieving the same etching effect and forming micro-pore or trench patterns disclosed in the prior arts.

After the formation of the micro-pore structures or trench structures on the surface of the silicon wafer substrate, an step of removing noble-metal alloyparticle canbe used by, for example, using an aqueous etchant solution to remove the residual noble-metal alloy particle, wherein the aqueous etchant solution are selected from hydrochloric acid (HCl) aqueous solution, sulfuric acid (H₂SO₄) aqueous solution, nitric acid (HNO₃) aqueous solution or the combination of any two or three.

As such, in the method of this invention for forming micro-pore structures or trench structures on a surface of a silicon wafer substrate, at least one noble-metal alloy particle is deposited to catalyze the oxidation of the silicon wafer substrate surface in contact therewith to form silicon dioxide, which is etched by an etchant, resulting in local micro-etching at the silicon wafer substrate and forming micro-pore structures or trench structures on the surface of the silicon wafer substrate. These micro-pore structures or trench structures reduce the surface reflectivity and increase the power conversion efficiency of the solar cells, and reduce the manufacturing costs by reducing the amount of noble-metals used during process, so as to increase the production benefits of the solar cells.

### BRIEF DESCRIPTION OF THE DRAWINGS

The structure and the technical means adopted by the present invention to achieve the above and other objects can be best understood by referring to the following detailed description of the preferred embodiments and the accompanying drawings, wherein

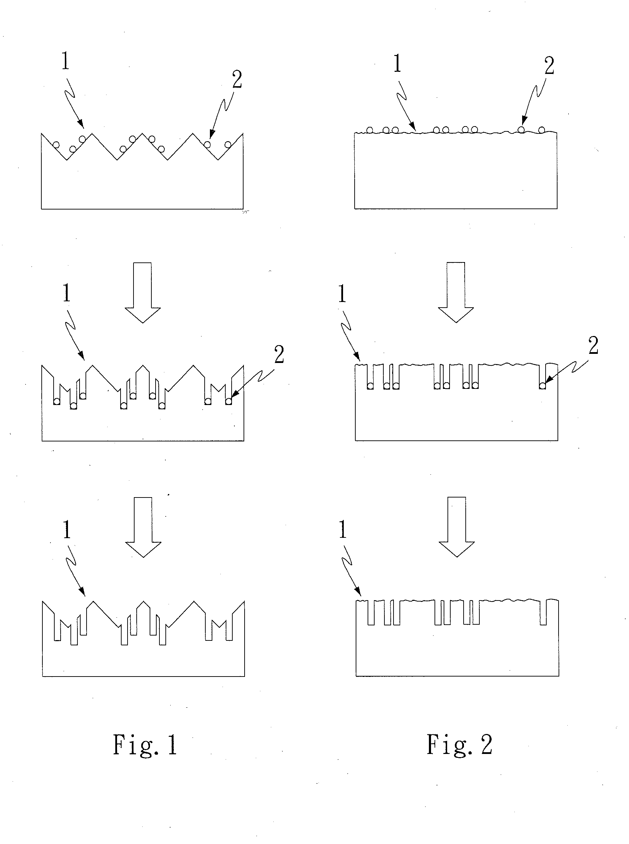

Fig. 1 and Fig. 2 are illustrative cross-sectional views of preferred embodiments of this invention.

### DETAILED DESCRIPTION OF THE PREFERRED EMBODIMENTS

Please refer to both Fig. 1 and Fig. 2 for illustrative sectional views of preferred embodiments of this invention, in which steps used at different stages in this invention are separately shown. First, a silicon wafer substrate 1 is provided, and then an alloy electroless co-plating technique is employed to form noble-metal alloy particle 2 on silicon wafer substrate 1. Next, aqueous etchant solution (not shown) is used to carry out a chemical wet etching process on the surface of siliconwafer substrate 1 to formmicro-pore structures or trench structures, wherein the aqueous etchant solution contains hydrogen fluoride or hydrogen peroxide. Noble-metal alloy particle 2 is located in the micro-pore structures or trench structures during the etching process. In the final step, another mixed etchant aqueous etchant solution containing hydrochloric acid, sulfuric acid and nitric acid is used on the surface of siliconwafer substrate 1 containing noble-metal alloy particle 2 to carry out a removal step which completely removes noble-metal alloy particle 2 to finish the formation of micro-pore structures or trench structures on the surface of silicon wafer substrate 1.

Embodiment 1

A pre-cut mono-crystalline silicon wafer (150 centimeters in dimension) with a smooth surface is prepared, and the following aqueous solutions are prepared.

Wash solution: aqueous solution containing 30% of hydrogen peroxide and 98% of concentrated sulfuric acid mixed at a volume ratio of 1:4.

Electroless co-plating solution: aqueous solution containing 0.05 Mole/L of silver nitrate (AgNO₃), 0.05 Mole/L of zinc nitrate (Zn(NO₃)₂), and 1.0 Mole/L of sodium hydroxide (NaOH).

Etchant: aqueous solution containing 10% of hydrogen fluoride and 30% of hydrogen peroxide mixed at a volume ratio of 10:1.

The wafer is soaked in the wash solution for 10 minutes. Then after subsequent water rinse, the wafer is soaked in the electroless co-plating solution for about 20 minutes to deposit silver-zinc alloy particle(s) on the wafer surface. After that and subsequent water rinse, the wafer containing silver-zinc alloy particle(s) on the wafer surface is soaked in the etchant for 10 to 30 minutes.

Embodiment 2

Conditions and steps of Embodiment 1 are used except that 0.05 Mole/L of zinc nitrate (Zn(NO₃)₂) in the electroless co-plating solution is replaced by 0.02 Mole/L of tin sulfate (SnSO₄).

Embodiment 3

Conditions and steps of Embodiment 1 are used except that silver nitrate and zinc nitrate of the electroless co-plating solution are replaced by silver sulfate (Ag₂SO₄) and zinc sulfate (ZnSO₄) respectively.

Embodiment 4

Conditions and steps of Embodiment 1 are used except that 0.01 Mole/L of sodium borate reducing agent is additionally included in the electroless co-plating solution.

with a scanning electron microscope (SEM), it can be observed on wafer surfaces soaked by the electroless co-plating solutions that the diameter of the deposited noble-metal alloy particle(s) typically ranges from 10 nanometers to 100 nanometers; in addition, SEM observation of the surfaces and cross-sections of the etchant-soaked wafers (pre-deposited with noble-metal alloy particle(s)) indicates the formation of micro-pore structures with a diameter (for example) from 70 nanometers to 100 nanometers and a depth (for example) from 2 micrometers to 10 micrometers.

Accordingly, this invention is novel in regard to its catalyst material, non-obvious, and industrially applicable and is thereby patentable. Regarding novelty and non-obviousness, this invention discloses the formation of at least one noble-metal alloy particle for effectively increasing the chemical etching on the surface of a silicon wafer substrate and forming micro-pore structures or trench structures thereon. Thus, the manufacturing costs can be reduced by reducing the amount of noble-metal used during the process, thereby to lower the production costs of solar cells. Regarding industrial applicability, the methods disclosed and the products to be made according to this invention can fully satisfy the market demand.

Thus, while the present invention has been fully described above with particularity and details in connection with what is presently deemed to be the most practical and preferred embodiment of the invention, it will be apparent to those of ordinary skill in the art that numerous modifications, including, but not limited to, variations in dimension, materials, shape, form, function and manner of operation, assembly and use may be made, without departing from the principles and concepts of the invention as set forth in the claims.

## Claims

1. A method of forming micro-pore structures or trench structures on a surface of a silicon wafer substrate, the method comprising:
(A)forming at least a noble-metal alloy particle on the surface of the silicon wafer substrate, the noble-metal alloy particle comprising at least two elements, at least one of which is selected from silver (Ag), gold (Au), platinum (Pt) or palladium (Pd) ; and
(B) then followed by employing an aqueous etchant solution to perform a wet chemical etching process on the surface of the silicon wafer substrate, the aqueous etchant solution comprising at least one acidic compound capable of releasing fluoride ion in the aqueous etchant solution and at least one oxygen-containing oxidizer.

2. The method according to claim 1, wherein the noble-metal alloy particle is a binary alloy, a ternary alloy or a quaternary alloy.

3. The method according to claim 2, wherein the noble-metal alloy particle comprises a non-noble-metal element selected from aluminum (Al), gallium (Ga), indium(In), magnesium (Mg), tin (Sn), zinc (Zn), copper (Cu), manganese (Mn), nickel (Ni), cobalt (Co) or antimony (Sb).

4. The method according to claim 2, wherein the noble-metal alloy particle is a binary alloy of silver and is selected from the following binary alloys:silver-aluminum (Ag-Al) alloy, silver-gallium (Ag-Ga) alloy, silver-indium (Ag-In) alloy, silver-magnesium (Ag-Mg) alloy, silver-tin (Ag-Sn) alloy, silver-zinc (Ag-Zn) alloy or silver-manganese (Ag-Mn) alloy.

5. The method according to claim 2, wherein the noble-metal alloy particle is a binary alloy of gold and is selected from the following binary alloys: gold-aluminum (Au-Al) alloy, gold-chromium (Au-Cr) alloy, gold-gallium (Au-Ga) alloy, gold-copper (Au-Cu) alloy, gold-indium (Au-In) alloy, gold-manganese (Au-Mn) alloy, gold-tin (Au-Sn) alloy or gold-zinc (Au-Zn) alloy.

6. The method according to claim 2, wherein the noble-metal alloy particle is a binary alloy of platinum and is selected from the following binary alloys: platinum-aluminum (Pt-Al) alloy, platinum-copper (Pt-Cu) alloy, platinum-indium (Pt-In) alloy, platinum-magnesium (Pt-Mg) alloy, platinum-tin (Pt-Sn) alloy, platinum-zinc (Pt-Zn) alloy, platinum-manganese (Pt-Mn) alloy, platinum-nickel (Pt-Ni) alloy or platinum-cobalt (Pt-Co) alloy.

7. The method according to claim 2, wherein the noble-metal alloy particle is a binary alloy of palladium and is selected from the following binary alloys: palladium-aluminum (Pd-Al) alloy, palladium-copper (Pd-Cu) alloy, palladium-indium (Pd-In) alloy, palladium-magnesium (Pd-Mg) alloy, palladium-tin (Pd-Sn) alloy, palladium-zinc (Pd-Zn) alloy, palladium-manganese (Pd-Mn) alloy, palladium-nickel (Pd-Ni) alloy or palladium-cobalt (Pd-Co) alloy.

8. The method according to claim 2, wherein the noble-metal alloy particle is abinaryalloycomprising two noble-metals and is selected from the following binary alloys: silver-gold (Ag-Au) alloy, silver-platinum (Ag-Pt) alloy, silver-palladium (Ag-Pd) alloy, gold-platinum (Au-Pt) alloy, gold-palladium (Au-Pd) alloy or platinum-palladium (Pt-Pd) alloy.

9. The method according to claim 2, wherein the noble-metal alloy particle is a nanoparticle binary alloy which has a particle feature size less than about 10 nanometers and is selected from the following nanoparticle alloys: silver-nickel (Ag-Ni) nanoparticle alloy, silver-cobalt (Ag-Co) nanoparticle alloy, gold-cobalt (Au-Co) nanoparticle alloy or gold-nickel (Au-Ni) nanoparticle alloy.

10. The method according to claim 2, wherein the noble-metal alloy particle has a particle feature size from 1 nanometer to 5000 nanometers.

11. The method according to claim 1, wherein the noble-metal alloy particle is formed on the surface of the silicon wafer substrate in step (A) by the process (es) selected from: an alloy electroless co-plating technique, an alloy electro co-plating technique, an alloy electro-phoresis technique, a stencil printing technique, an ink-jet printing technique, a spraying technique, a sputtering technique or a co-evaporating technique.

12. The method according to claim 1, wherein the acidic compound capable of releasing fluoride ion in the aqueous etchant solution in step (B) is selected from: hydrogen fluoride (HF), ammonium fluoride (NH₄F), ammonium hydrogen fluoride (NH₄HF₂), metal salt or ammonium salt of hydrogen fluoride, trifluoroacetic acid (CF₃CO₂H), metal salt or ammonium salt of trifluoroacetic acid, tetrafluoroboric acid (HBF₄), metal salt or ammonium salt of tetrafluoroboric acid, hexafluorosilicic acid ((NH₄)₂(SiF₆)), or metal salt or ammonium salt of hexafluorosilicic acid.

13. The method according to claim 12, wherein the acidic compound is hydrogen fluoride or ammonium fluoride.

14. The method according to claim 1, wherein the oxygen-containing oxidizer in step (B) is selected from: hydrogen peroxide (H₂O₂), ozone (O₃), sodium persulfate (Na₂S₂O₈), potassium permanganate (KMnO₄), nitric acid (HNO₃), ammonium nitrate (NH₄NO₃), sulfuric acid (H₂SO₄), ammonium sulfate ((NH₄)₂SO₄), ammonium peroxydisulfate ((NH₄)₂S₂O₈), potassium peroxydisulfate (K₂S₂O₈), perchloric acid (HClO₄), ammonium perchlorate (NH₄ClO₄), sodium perchlorate (NaClO₄), potassium perchlorate (KClO₄), periodic acid (HIO₄ 2H₂O), sodium periodate (NaIO₄), potassium periodate (KIO₄), methanesulfonic acid (CH₃SO₂OH) or ethylenediamine sulphate (C₂H₁₀N₂SO₄).

15. The method according to claim 14, wherein the oxygen-containing oxidizer is hydrogen peroxide or ozone.

16. The method according to claim 1, further comprising a removal step which performs partial or complete removal of the noble-metal alloy particle(s) on the surface of the silicon wafer substrate containing the noble-metal alloy particle(s).

17. The method according to claim 16, wherein the removal step is performed using a wet etching process of an aqueous etchant solution selected from hydrochloric acid (HCl) aqueous solution, sulfuric acid (H₂SO₄) aqueous solution, nitric acid (HNO₃) aqueous solution and the combination thereof.
